(19) Europäisches Patentamt
European Patent Office
Office européen des brevets

(11) **EP 3 311 114 B1**

(12) **EUROPÄISCHE PATENTSCHRIFT**

(45) Veröffentlichungstag und Bekanntmachung des Hinweises auf die Patenterteilung:
**24.04.2019 Patentblatt 2019/17**

(21) Anmeldenummer: **16729516.1**

(22) Anmeldetag: **07.06.2016**

(51) Int Cl.:
*G01D 5/22* (2006.01)        *G01D 18/00* (2006.01)
*G01D 5/20* (2006.01)        *G01R 31/02* (2006.01)
*G01R 31/28* (2006.01)

(86) Internationale Anmeldenummer:
**PCT/EP2016/062839**

(87) Internationale Veröffentlichungsnummer:
**WO 2016/202626 (22.12.2016 Gazette 2016/51)**

(54) **VERFAHREN UND SCHALTUNG ZUM ERKENNEN EINES KURZSCHLUSSES EINER RESOLVER-ERREGERLEITUNG NACH MASSE ODER ZUR BETRIEBSSPANNUNG**

METHOD AND CIRCUIT FOR DETECTING A SHORT CIRCUIT OF A RESOLVER EXCITER LINE TO GROUND OR TO THE OPERATING VOLTAGE

PROCÉDÉ ET CIRCUIT POUR DÉTECTER UN COURT-CIRCUIT D'UNE LIGNE D'EXCITATION DE RÉSOLVEUR VERS LA MASSE OU UNE TENSION DE SERVICE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **18.06.2015 DE 102015211214**

(43) Veröffentlichungstag der Anmeldung:
**25.04.2018 Patentblatt 2018/17**

(73) Patentinhaber: **Robert Bosch GmbH**
**70442 Stuttgart (DE)**

(72) Erfinder:
• **UNGERMANN, Michael**
**64285 Darmstadt (DE)**
• **LECHNER, Benjamin**
**75242 Neuhausen (DE)**
• **RAICHLE, Daniel**
**71665 Vaihingen (DE)**
• **ZIRKEL, Daniel**
**75446 Wiernsheim-Serres (DE)**

(56) Entgegenhaltungen:
EP-A2- 1 548 411        EP-A2- 1 942 315
EP-A2- 2 078 933        DE-A1-102010 007 349

## Beschreibung

Die Erfindung betrifft ein Verfahren zum Erkennen eines Kurzschlusses einer Resolver-Erregerleitung nach Masse oder zur Betriebsspannung, und sie umfasst auch eine Schaltung zum Realisieren dieses Verfahrens.

Stand der Technik

Resolver dienen zum Ermitteln der Winkelstellung eines rotierenden Objekts, z.B. der Antriebswelle eines Motors. Im Stand der Technik gibt es verschiedene Resolvertypen.

Die EP 1 548 411 A1 beschreibt eine Vorrichtung zum Erkennen eines Kurzschlusses auf der Erregerseite eines Resolvers.

Grundsätzlich wird dabei mittels mindestens einer Spule ein sich änderndes magnetisches Feld erzeugt, und mittels mindestens einer weiteren Spule wird dieses Feld detektiert, wobei die Stärke der Kopplung zwischen den Spulen in Abhängigkeit von der zu messenden Position oder Winkelstellung variiert. Beim "Variable Reluctance Resolver" (VR-Resolver) beispielsweise kommt nur eine Erregerspule zum Einsatz und es gibt zwei Messspulen, die positionsabhängige Signale erzeugen. Die deutsche Patentanmeldung DE 10 2011 078 583 A1 offenbart beispielsweise eine Auswertung von Resolver-Sensorsignalen in einem Fahrzeug. Ein Resolver nimmt hierzu eine Drehbewegung eines Rotors auf, und ein Prozessorelement verarbeitet die sinus- bzw. kosinusförmigen Ausgangssignale des Resolvers.

Die Erfindung geht von einem solchen Resolver aus, wobei das Erregersignal sinusförmig ist und typischer Weise eine Frequenz von 10 kHz hat. Die beiden Messspulen sind in der Regel orthogonal zueinander positioniert und werden als

Sinus- und Kosinusspule bezeichnet. Mit den beiden Messsignalen ist der Winkel des Messobjekts eindeutig bestimmbar.

Das Erregersignal für die Erregerspule kann beispielsweise durch zwei Gegentaktendstufen bereitgestellt werden, je eine für die beiden Anschlüsse der Erregerspule. Die Ausgangssignale der beiden Endstufen sind dann um 180° zueinander phasenverschoben und das für die Erregerspule wirksame Erregersignal ist die Differenzspannung zwischen den Ausgängen der beiden Endstufen.

Es besteht aber auch die Möglichkeit, die Erregerspule durch nur eine Endstufe zu betreiben. Der zweite Anschluss der Erregerspule ist dann entweder direkt oder über einen Kondensator auf ein festes Potential, z. B. Massepotential gelegt.

An den Empfängerspulen entsteht ein Wechselspannungssignal mit derselben Frequenz wie das Erregersignal, dessen Amplitude jedoch entsprechend der Rotorlage moduliert ist, wobei das Signal an der Kosinusspule um 90° gegenüber dem Signal an der Sinusspule phasenverschoben ist.

Resolver werden häufig zur Regelung von permanenterregten Synchronmaschinen (PSM) und elektrisch erregten Synchronmaschinen (ESM) eingesetzt, die z.B. als Antrieb für Hybrid- und Elektrofahrzeuge Verwendung finden. Für eine solche Regelung ist die Kenntnis der aktuellen Rotorwinkellage notwendig. Für die Regelung von Asynchronmaschinen (ASM) ist die Kenntnis der aktuellen Frequenz des Antriebs erforderlich.

Wegen ihrer Robustheit werden in Kraftfahrzeugen für diese Zwecke bevorzugt Resolver eingesetzt, auch wenn es alternative Sensoren gibt, z.B. digitale Winkelgeber oder Sensoren auf der Basis des Wirbelstromeffekts.

Sensoren im Automobilbereich müssen zum Erfüllen von Anforderungen der funktionalen Sicherheit und der Gesetzgebung diagnostiziert werden. Bei Resolvern, wie sie die vorliegende Anmeldung zum Gegenstand hat, ist ein möglicher, zu diagnostizierender Fehler ein Kurzschluss einer Resolver-Erregerleitung nach Masse oder zur Betriebsspannung. Dabei wird im Folgenden unter einem Kurzschluss nur eine ungewollte elektrische Verbindung eines der Anschlüsse der Resolver-Erregerleitung mit Masse oder mit der Betriebsspannung verstanden, wobei die Diagnose auch feststellen soll, mit welchem dieser Potentiale die ungewollte Verbindung besteht.

Im Stand der Technik wird ein solcher Fehler dadurch diagnostiziert, dass beide Empfängersignale (Sinus und Kosinus) nicht mehr vorhanden sind. Eine solche Diagnose reicht jedoch nicht aus, weil das Ausbleiben von Sinus- und Kosinussignal auch andere Ursachen haben kann, z.B. eine offene Erregerleitung. Der Fehler kann auf Grund der bloßen Signale an den Signalleitungen nicht weiter eingegrenzt werden.

Offenbarung der Erfindung

Das Verfahren zum Erkennen eines Kurzschlusses einer Resolver-Erregerleitung, umfasst zunächst das permanente Messen der Erregerspannung für den Resolver zu einer Vielzahl von Zeitpunkten während jeder Erregerperiode. Aus diesem Signalverlauf wird die Amplitude der Erregerspannung ermittelt und es wird ein Diagnosemodus gestartet, falls die Amplitude einen ersten Schwellenwert nicht erreicht oder insbesondere unterschreitet. Im Diagnosemodus wird der Spannungsverlaufs der beiden Erregerleitungen einzeln gegen Masse zu einer Mehrzahl von Zeitpunkten während einer oder mehrerer Erregerperioden gemessen, und aus diesem Signalverlauf werden die Amplituden und die Offsetwerte beider Signale bestimmt. Überschreitet eine der Amplituden einen zweiten Schwellenwert nicht oder unterschreitet eine der Amplituden einen zweiten Schwellenwert, wird die zugehörige Erregerleitung als kurzschlussbehaftet identifiziert. Das Identifizieren des Potentials, auf das die kurzschlussbehaftete Leitung gezogen wird, erfolgt durch Vergleichen des zugehörigen Offsetwerts mit dritten Grenzwerten.

Ein anderer Aspekt der Erfindung besteht in einer Schaltung, die dieses Verfahren realisiert. Die Schaltung geht aus von der zu untersuchenden Schaltung, die eine Steuervorrichtung mit einem Prozessor, Leistungsstufen und erste Anschlüssen zum Bereitstellen der Signale für die Erregerleitungen umfasst, sowie zwei AD-Wandler, die an zweite Anschlüsse der Steuereinrichtung für die Signalleitungen angeschlossen sind und deren Ausgänge von der Software des Prozessors lesbar und auswertbar sind.

Weiterhin gehören zu der Schaltung die zu diagnostizierenden Erregerleitungen zu der Erregerspule des Resolvers und die Signalleitungen für das Sinus- und Kosinussignal, die den Resolver mit der Steuervorrichtung koppeln. Für die Diagnose umfasst die Schaltung einen dritten AD-Wandler, dessen Eingänge mit den ersten Anschlüssen für die Erregerleitungen verbunden sind, einen vierten AD-Wandler, dessen erster Eingang mit einem der ersten Anschlüsse für die Erregerleitung und dessen zweiter Eingang mit Masse verbunden ist und einen fünften AD-Wandler, dessen erster Eingang mit dem anderen der ersten Anschlüsse für die Erregerleitung und dessen zweiter Eingang mit Masse verbunden sind. Außerdem umfasst die Schaltung eine Anzeige- und/oder Speichereinrichtung zum Anzeigen und/oder Speicher der vom Prozessor identifizierten Informationen, in die das positive Erkennen eines Kurzschlusses der Erregerleitungen des Resolvers und das Bezeichnen der kurzschlussbehafteten Leitung und des Potentials, auf das diese Leitung ziehbar ist, einbezogen ist. Alternativ zum vierten und fünften AD-Wandler können zwei elektronische Schalter vorgesehen werden, die in die Verbindung der Anschlüsse für die Erregerleitungen zu Eingängen des dritten AD-Wandler eingefügt sind und den jeweiligen Eingang des AD-Wandlers von der Erregerleitung abtrennen und temporär mit Masse verbinden. Der Prozessor ist dazu ausgestaltet, die Verfahrensschritte des oben genannten Verfahren zum Erkennen eines Kurzschlusses einer Resolver-Erregerleitung umzusetzen.

Vorteile der Erfindung

Der Vorteil der Erfindung besteht darin, dass der zu diagnostizierende Fehler exakt von anderen Fehlern unterschieden werden kann (PinPointing-Diagnose). Die Diagnose ist auch sehr schnell, denn bereits nach wenigen Perioden des Erregersignals mit einer typischen der Dauer von 0,1 msec liegt eine zuverlässige Fehlerdiagnose vor, und es können ggf. geeignete Maßnahmen ergriffen werden. Damit werden insbesondere Anforderungen an Sensoren im Automobilbereich im Hinblick auf funktionelle Sicherheit wie auch im Hinblick auf OBD-Gesetzgebung (OBD = On Board Diagnose) erfüllt. Vorteilhaft ist weiterhin, dass das erfindungsgemäße Verfahren mit minimaler Ergänzung der üblichen Hardware einer Resolveransteuerung realisiert werden kann.

Kurze Beschreibung der Zeichnungen

Fig. 1 zeigt eine Schaltung gemäß einem Ausführungsbeispiel der Erfindung.

Fig. 2 erläutert symbolisch die Verfahrensschritte zum Ausführen des Verfahrens gemäß einem Ausführungsbeispiel der Erfindung.

Fig. 3 zeigt Einzelheiten im zeitlichen Verlauf der Potentiale an den Erregerleitungen des Resolvers bei Eintritt des Fehlerfalles.

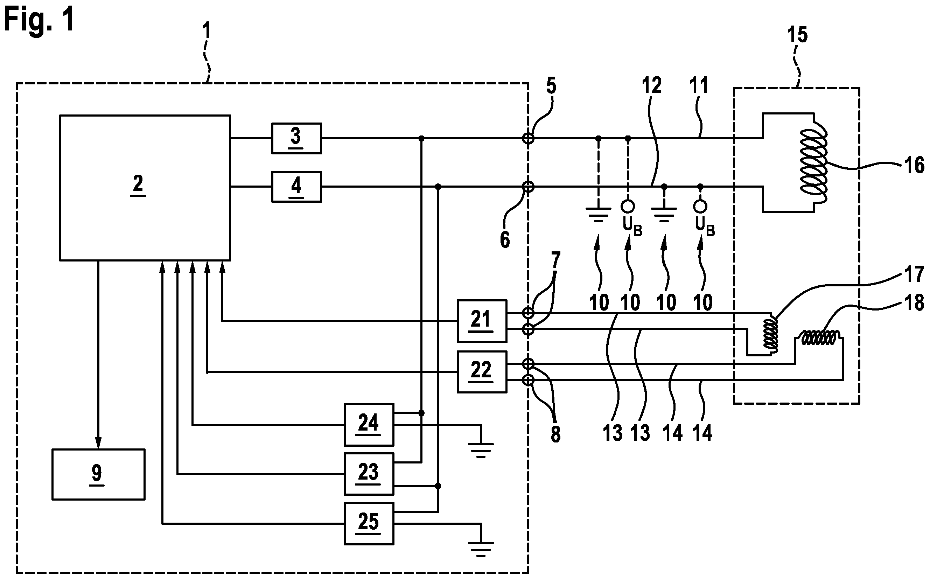

In Figur 1 steht die Steuervorrichtung 1 für den Resolver 15 im Zentrum, die in die Steuereinrichtung für ein Fahrzeug integriert sein kann (hier nicht dargestellt). Sie weist einen Prozessor 2 auf (oder nutzt diesen mit), der den korrekten Ablauf aller zu steuernden Resolverfunktionen überwacht und auch ggf. Fehlfunktionen anzeigt.

Die Steuervorrichtung 1 steuert insbesondere die Leistungsstufen 3 und 4 zum Bereitstellen des sinusförmigen Erregersignals für die Erregerspule 16 des Resolvers 15 an den ersten Anschlüssen 5 und 6. An den zweiten Anschlüssen 7 und 8 gelangen die Signale der Sinusspule 17 und der Kosinusspule 18, die die momentane Winkelstellung des Messobjekts (z.B. der Welle des Motors) repräsentieren, zur Steuervorrichtung 1 und können nach Wandlung in den AD-Wandlern 21 und 22 als digitales Signal softwaremäßig weiter bearbeitet werden.

Die Resolver-Erregerleitungen 11 und 12 stellen die Verbindung von den ersten Anschlüssen 5 und 6 der Steuervorrichtung 1 zum Resolver 15, nämlich zu dessen Erregerspule 16 dar. Diese Leitungen gilt es im Hinblick auf einen Kurzschluss, d.h. einer unerwünschten Verbindung nach Masse oder zur Betriebsspannung $U_B$ zu überwachen, was in Figur 1 mit den potentiellen, punktiert dargestellten Verbindungen 10 angedeutet ist. Von der Sinusspule 17 und der Kosinusspule 18 des Resolvers 15 gehen die Signalleitungen 13 und 14 zu den zweiten Anschlüssen 7 und 8 der Steuervorrichtung 1.

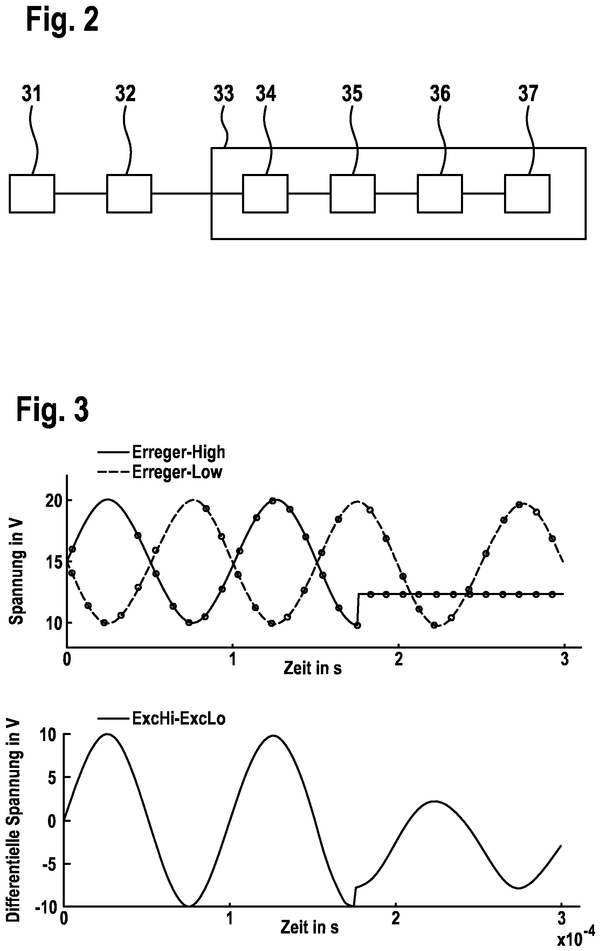

Für den ersten Schritt der erfindungsgemäßen Diagnose, das Messen der Erregerspannung (Schritt 31 in Figur 2), ist ein einen dritter AD-Wandler 23 vorgesehen, dessen Eingänge mit den ersten Anschlüssen 5 und 6 für die Erregerleitungen 11 und 12 verbunden sind. Über diesen AD-Wandler 21 erfolgt permanent das Messen der Erregerspannung $U(t_i)$ für den Resolver 16 zu einer Vielzahl von Zeitpunkten $t_i$ während jeder Erregerperiode. Aus diesen Daten ermittelt der Prozessor 2 für die Diagnose die Amplitude $U_M$ der Erregerspannung (Schritt 32 in Figur 2). Dies z.B. kann geschehen, indem für jede Erregerperiode das Maximum $U_{max}$ und das Minimum $U_{min}$ der Messwerte der Erregerspannung $U(t_i)$ gesucht und die Amplitude $U_M$ durch die halbe Differenz dieser Werte $(U_{max}-U_{min})/2$ gebildet wird.

Wie Figur 3 erläutert, bricht die Signalamplitude der Spannung $U(t_i)$ bei einem zu diagnostizierenden Kurzschluss ein (Figur 3, rechts), da dann nur noch eine oder sogar gar keine der Leistungsstufen 3 und 4 zur Signalamplitude beitragen kann. Somit kann ein Diagnosemodus 33 gestartet werden, wenn die Amplitude $U_M$ der Erregerspannung einen ersten Schwellenwert $C_{S1}$ nicht erreicht.

Für den Diagnosemodus 33 wird der Spannungsverlaufs der einzelnen Erregerleitungen 11 und 12 gegen Masse ausgewertet, wobei nachfolgend für die Leitung 11 auch der Index H (oder High) und für die Leitung 12 der Index L (oder Low) verwendet wird. Die Erregerleitung 11 kann dazu mit einem der beiden Eingänge eines vierten AD-Wandlers 24 verbunden sein, während dessen anderer Eingang auf Masse gelegt ist, und die andere Erregerleitung 12 wird mit einem der beiden Eingänge eines fünften AD-Wandlers 25 verbunden, und auch dessen anderer Eingang ist auf Masse gelegt. Der dritte, vierte und fünfte AD-Wandler 23, 24 und 25 sind in die Steuervorrichtung 1 integriert. Diese Ausführungsart ist in Figur 1 dargestellt.

Alternativ zu den AD-Wandlern 24 und 25 können zwei elektronischen Schalter vorgesehen werden (in Figur 1 nicht dargestellt), die in die Verbindung der Anschlüsse 5 und 6 für die Erregerleitungen 11, 12 zu Eingängen des dritten AD-Wandler 23 eingefügt sind, wobei die Schalter so eingerichtet sind, dass sie jeweils einen Eingang des AD-Wandlers 23 von der Erregerleitung 5 bzw. 6 abtrennen und diesen Eingang temporär mit Masse verbinden.

Im Diagnosemodus 33 werden zu einer Mehrzahl von Zeitpunkten $t_i$ während der Messzeit von einer oder mehrerer Erregerperioden die Spannungswerte $U_H(t_i)$ am Anschluss 5 der ersten Erregerleitung (H; 11) gegen Masse und die Spannungswerte $U_L(t_i)$ am Anschluss 6 der zweiten Erregerleitung (L; 12) gegen Masse durch den Prozessor 2 abgefragt (Schritt 34), und zwar über den vierten und fünften AD-Wandler 24 und 25, oder aber alternativ über den dritten AD-Wandlern 23 nach temporärem Umlegen des jeweiligen zusätzlichen Schalters am jeweils anderen Eingang des dritten AD-Wandlers 23 auf Masse während der Messzeit.

Mit den so erfassten Signalen $U_H(t_i)$ und $U_L(t_i)$ erfolgt das Berechnen 35 der Amplituden $U_{HA}$ und $U_{LA}$ und der Offsetwerte $U_{HO}$ und $U_{LO}$ durch den Prozessor 2, wofür es unterschiedliche Möglichkeiten gibt. Eine davon besteht darin, die Maxima
$max(U_H(t_i))$ und $max(U_L(t_i))$
und die Minima
$min(U_H(t_i))$ und $min(U_L(t_i))$
der Signale $U_H(t_i)$ und $U_L(t_j)$ zu suchen, und das Berechnen der Amplituden und Offsetwerte erfolgt dann nach den Formeln

$$U_{HA} = 1/2 * [max(U_H(t_i)-min(U_H(t_i))]$$

$$U_{LA} = 1/2 * [max(U_L(t_i)-min(U_L(t_i))]$$

$$U_{HO} = 1/2 * [max(U_H(t_i)+min(U_H(t_i))]$$

und

$$U_{LO} = 1/2 * [max(U_L(t_i)+min(U_L(t_i))] .$$

Das Identifizieren 36 der Leitung, die einen Kurzschluss aufweist (H oder L), erfolgt durch das Feststellen, dass die Amplitude $U_{HA}$ oder $U_{LA}$ einen zweiten Grenzwert nicht überschreitet, denn wenn diese Leitung auf einem festen Potential liegt, kann sich kein schwankendes Signal und damit keine Amplitude ausbilden. Der Offsetwert, das heißt die Spannung, die am vierten oder fünften AD-Wandler im Fehlerfall ansteht, zeigt an mit welchem Potential der Kurzschluss erfolgt ist, indem der Offsetwert $U_{HO}$ oder $U_{LO}$ mit einem Schwellenwert $C_{SCG}$ für das Massepotential und mit einem Schwellenwert $C_{SGB}$ für das Betriebsspannungspotential verglichen werden, gemäß den Formeln

$U_{HO} < C_{SCG}$ (Massepotential auf Leitung H)
$U_{HO} > C_{SGB}$ (Betriebsspannungspotential auf Leitung H)
$U_{LO} < C_{SCG}$ (Massepotential auf Leitung L), und
$U_{LO} > C_{SGB}$ (Betriebsspannungspotential auf Leitung L).

Auf der Basis der Feststellung, welcher dieser vier Fälle vorliegt, können die erforderlichen Maßnahmen erfolgen; insbesondere wird das Feststellen des Fehlers mit einer Anzeige- und/oder Speichereinrichtung 9 angezeigt bzw. gespeichert. Die Anzeige- und/oder Speichereinrichtung 9 dient generell zum Anzeigen und/oder Speichern von Informationen, die vom Prozessor 2 ermittelt wurden. Das positive Erkennen eines Kurzschlusses und das Bezeichnen der kurzschlussbehafteten Leitung 11 oder 12 und des Potentials (Masse oder $U_B$), auf das diese Leitung gezogen wird, ist in diese Anzeige einbezogen. Dabei kann die kurzschlussbehaftete Leitung z.B. mit ihrer Farbe oder Bezugsnummer bezeichnet werden.

**Patentansprüche**

1. Verfahren zum Erkennen eines Kurzschlusses (10) einer Resolver-Erregerleitung (11, 12), mit den Schritten:

   • Messen (31) der Erregerspannung ($U(t_i)$) für den Resolver (16) zu einer Vielzahl von Zeitpunkten während jeder Erregerperiode;

• Ermitteln (32) der Amplitude der Erregerspannung;

• Starten eines Diagnosemodus (33) mit den nachfolgenden Schritten (34 bis 37), wenn die Amplitude der Erregerspannung einen ersten Schwellenwert nicht erreicht;

• Abfragen (34) der zeitabhängigen Spannungsverläufe $U_H(t_i)$ der ersten und zweiten Erregerleitung (H; 11) gegen Masse zu der Vielzahl von Zeitpunkten ;

• Berechnen (35) der Amplituden und der Offsetwerte der zeitabhängigen Spannungsverläufe;

• Identifizieren (36) der Erregerleitung , die einen Kurzschluss aufweist, durch das Feststellen, dass die berechneten Amplituden einen zweiten Grenzwert nicht überschreiten;

• Identifizieren (37) des Potentials, auf das die kurzschlussbehaftete Leitung (H oder L) ziehbar ist, durch Vergleichen der Offsetwerte mit dritten Grenzwerten .

2. Verfahren nach Anspruch 1, wobei das Messen (31) erfolgt, indem beide Anschlüsse (5, 6) für die Erregerleitung auf die beiden Eingänge eines AD-Wandler (23) geführt werden.

3. Verfahren nach Anspruch 1 oder 2, wobei das Ermitteln (32) der Amplitude der Erregerspannung erfolgt, indem für jede Erregerperiode das Maximum und das Minimum der Messwerte der Erregerspannung ermittelt wird und die Amplitude durch die halbe Differenz des ermittelen Maximums und Minimums gebildet wird.

4. Verfahren nach einem der Ansprüche 1 bis 3, wobei das Abfragen (34) des Spannungsverlaufs $U_H(t_i)$ der ersten Erregerleitung gegen Masse dadurch erfolgt, dass der erste Eingang eines AD-Wandlers (23; 24), mit dem ersten Anschluss (5) für die Erregerleitung (11) verbunden ist und dessen zweiter Eingang zumindest für die Messzeit auf Massepotential gelegt ist,

und wobei das Messen des Spannungsverlaufs der zweiten Erregerleitung gegen Masse dadurch erfolgt, dass der erste Eingang eines AD-Wandlers (23; 25) zumindest für die Messzeit auf Massepotential gelegt ist und dessen zweiter Eingang mit dem zweiten Anschluss (6) für die Erregerleitung verbunden ist.

5. Verfahren nach einem der Ansprüche 1 bis 4, wobei das Berechnen (35) der Amplituden und der Offsetwerte der zeitabhängigen Spannungsverläufe erfolgt, indem die Maxima und die Minima der zeitabhängigen Spannungsverläufe ermittelt werden, die Amplituden durch die Differenz der ermittelten Maxima und die Minima der zeitabhängigen Spannungsverläufe, und die Offsetwerte durch die Summe der ermittelten Maxima und die Minima der zeitabhängigen Spannungsverläufe berechnet werden.

6. Verfahren nach einem der Ansprüche 1 bis 5, wobei das Identifizieren (36) des Potentials, auf das die kurzschlussbehaftete Leitung gezogen wird, erfolgt, indem die Offsetwerte mit einem Schwellenwert für das Massepotential und mit einem Schwellenwert für das Betriebsspannungspotential verglichen werden.

7. Schaltung zum Erkennen eines Kurzschlusses (10) einer Erregerleitung (11, 12) eines Resolvers (16), aufweisend

• eine Steuervorrichtung (1) mit einem Prozessor (2), Leistungsstufen (3 ,4), ersten Anschlüssen zum Bereitstellen von Signalen für die Erregerleitungen (11, 12) zur Erregerspule (16) des Resolvers(15) und zweiten Anschlüssen (7, 8) zum Anschließen der Signalleitungen (13, 14) für die Signale der Sinus- und der Kosinusspule (17, 18); und zwei AD-Wandler (21, 22), die an die zweiten Anschlüsse (7, 8) der Steuereinrichtung (1) angeschlossen sind und deren Ausgänge von dem Prozessor (2) lesbar und auswertbar sind;

• die zu diagnostizierenden Erregerleitungen (11, 12), die die ersten Anschlüsse (5, 6) mit der Erregerspule (16) des Resolvers (15) koppeln;

• die Signalleitungen (13, 14) für die vom Resolver (15) bereitgestellten Sinus- und Kosinussignale, die den Resolver mit den zweiten Anschlüssen (7, 8) der Steuervorrichtung (1) koppeln;

• einen dritten AD-Wandler (23), dessen Eingänge mit den ersten Anschlüssen (5, 6) für die Erregerleitungen (11, 12) verbunden sind;

•

- entweder:
einen vierten und einen fünften AD-Wandler (24, 25), bei denen jeweils ein Eingang mit Masse verbunden ist und der andere Eingang mit einem der ersten Anschlüsse (5, 6) für die Erregerleitungen (11, 12) verbunden ist;

- oder:
zwei elektronische Schalter, die in die Verbindung der Anschlüsse (5, 6) für die Erregerleitungen (11, 12) zu Eingängen des dritten AD-Wandler (23) eingefügt sind, wobei die Schalter so eingerichtet sind, dass sie jeweils einen Eingang des AD-Wandlers (23) von der Erregerleitung (11,12) abtrennen und diesen Eingang temporär mit Masse verbinden;
und

• eine Anzeige- und/oder Speichereinrichtung (9) zum Anzeigen und/oder Speichern der vom Prozessor (2) identifizierten Informationen, in die das positive Erkennen eines Kurzschlusses (10) der Erregerspule (17;18) eines Resolvers (16) und das Bezeichnen der kurzschlussbehafteten Leitung (11,12) und des Potentials, auf das diese Leitung ziehbar ist, einbezogen ist;

wobei der Prozessor (2) dazu ausgestaltet ist, das Verfahren (31-37) gemäß Anspruch 1 umzusetzen.

**8.** Schaltung nach Anspruch 7, wobei der dritte, vierte und fünfte AD-Wandler (23, 24, 25) oder der dritte AD-Wandler (23) und die zwei elektronischen Schalter in die Steuervorrichtung (1) integriert sind.

**Claims**

**1.** Method for detecting a short (10) in a resolver excitation line (11, 12), having the steps of:

• measuring (31) the excitation voltage ($U(t_i)$) for the resolver (16) at a multiplicity of times during each excitation period;
• ascertaining (32) the amplitude of the excitation voltage;
• starting a diagnosis mode (33) having the following steps (34 to 37) if the amplitude of the excitation voltage does not reach a first threshold value;
• calling up (34) the time-dependent voltage profiles $U_H(t_i)$ of the first and second excitation lines (H; 11) referenced to ground at the multiplicity of times;
• computing (35) the amplitudes and the offset values of the time-dependent voltage profiles;
• identifying (36) the excitation line that has a short by establishing that the computed amplitudes do not exceed a second limit value;
• identifying (37) the potential to which the shorted line (H or L) can be pulled by comparing the offset values with third limit values.

**2.** Method according to Claim 1, wherein the measuring (31) is effected by virtue of the two connections (5, 6) for the excitation line being routed to the two inputs of an AD converter (23).

**3.** Method according to Claim 1 or 2, wherein the ascertaining (32) of the amplitude of the excitation voltage is effected by virtue of the maximum and the minimum of the measured values of the excitation voltage being ascertained for each excitation period and the amplitude being formed by half the difference between the ascertained maximum and minimum.

**4.** Method according to one of Claims 1 to 3, wherein the calling up (34) of the voltage profile $U_H(t_i)$ of the first excitation line referenced to ground is effected by virtue of the first input of an AD converter (23; 24), to which the first connection (5) for the excitation line (11) is connected, and the second input thereof being at ground potential at least for the measurement time,
and wherein the measuring of the voltage profile of the second excitation line referenced to ground is effected by virtue of the first input of an AD converter (23; 25) being at ground potential at least for the measurement time and the second input thereof being connected to the second connection (6) for the excitation line.

**5.** Method according to one of Claims 1 to 4, wherein the computing (35) of the amplitudes and the offset values of the time-dependent voltage profiles is effected by virtue of the maxima and the minima of the time-dependent voltage profiles being ascertained, the amplitudes by virtue of the difference between the ascertained maxima and the minima of the time-dependent voltage profiles, and the offset values being computed by virtue of the sum of the ascertained maxima and the minima of the time-dependent voltage profiles.

**6.** Method according to one of Claims 1 to 5, wherein the identifying (36) of the potential to which the shorted line is pulled is effected by virtue of the offset values being compared with a threshold value for the ground potential and with a threshold value for the operating voltage potential.

**7.** Circuit for detecting a short (10) in an excitation line (11, 12) of a resolver (16), having

• a control apparatus (1) having a processor (2), power stages (3, 4), first connections for providing signals for the excitation lines (11, 12) for the excitation coil (16) of the resolver (15) and second connections (7, 8) for connecting the signal lines (13, 14) for the signals of the sine and cosine coils (17, 18); and two AD converters (21, 22) that are connected to the second connections (7, 8) of the control device (1) and the outputs of which can be read by the processor (2) and can be evaluated;
• the excitation lines (11, 12) to be diagnosed that couple the first connections (5, 6) to the excitation coil (16) of the resolver (15);
• the signal lines (13, 14) for the sine and cosine signals provided by the resolver (15), which couple the resolver to the second connections (7, 8) of the control apparatus (1);
• a third AD converter (23), the inputs of which are connected to the first connections (5, 6) for the excitation lines (11, 12);
•

- either:
a fourth and a fifth AD converter (24, 25), in the case of which in each case one input is connected to ground and the other input is connected to one of the first connections (5, 6) for the excitation lines (11, 12);
- or:
two electronic switches that are inserted into the connection between the connections (5, 6) for the excitation lines (11, 12) and inputs of the third AD converter (23), the switches being set up such that they respectively disconnect an input of the AD converter (23) from the excitation line (11, 12) and temporarily connect this input to ground;

and
• a display and/or memory device (9) for displaying and/or storing the information identified by the processor (2) that incorporates the positive detecting of a short (10) in the excitation coil (17; 18) of a resolver (16) and the denoting of the shorted line (11, 12) and the potential to which this line can be pulled;
wherein the processor (2) is configured to implement the method (31-37) according to Claim 1.

8. Circuit according to Claim 7, wherein the third, fourth and fifth AD converters (23, 24, 25) or the third AD converter (23) and the two electronic switches are integrated in the control apparatus (1).

**Revendications**

1. Procédé de détection d'un court-circuit (10) d'une ligne d'excitation (11, 12) de résolveur, comportant les étapes suivantes :

• mesure (31) de la tension d'excitation ($U(t_i)$) pour le résolveur (16) à une multiplicité de points temporels pendant chaque période d'excitation ;
• détermination (32) de l'amplitude de la tension d'excitation ;
• démarrage d'un mode diagnostic (33) avec les étapes suivantes (34 à 37) si l'amplitude de la tension d'excitation n'atteint pas une première valeur seuil ;
• consultation (34) des évolutions de tension à dépendance temporelle $U_H(t_i)$ de la première et de la deuxième ligne d'excitation (H ; 11) par rapport à la masse à une multiplicité de points temporels ;
• calcul (35) des amplitudes et des valeurs de décalage des évolutions de tension à dépendance temporelle ;
• identification (36) de la ligne d'excitation qui présente un court-circuit par la constatation que les amplitudes calculées ne dépassent pas une deuxième valeur limite ;
• identification (37) du potentiel sur lequel la ligne affectée de court-circuit (H ou L) peut être tirée par comparaison des valeurs de décalage avec des troisièmes valeurs limite.

2. Procédé selon la revendication 1, dans lequel la mesure (31) a lieu par le fait que les deux raccordements (5, 6) pour la tension d'excitation sont guidés vers les deux entrées d'un convertisseur AD (23).

3. Procédé selon la revendication 1 ou 2, dans lequel la détermination (32) de l'amplitude de la tension d'excitation a lieu par le fait que, pour chaque période d'excitation, le maximum et le minimum des valeurs de mesure de la tension d'excitation sont déterminés et l'amplitude est constituée par la moitié de la différence entre le maximum et le minimum déterminés.

4. Procédé selon une des revendications 1 à 3, dans lequel la consultation (34) de l'évolution de tension $U_H(t_i)$ de la première ligne d'excitation par rapport à la masse a lieu du fait que la première entrée d'un convertisseur AD (23 ; 24) est connectée au premier raccordement (5) pour la ligne d'excitation (11) et que sa seconde entrée, au moins pour la durée de mesure, est mise au potentiel de masse, et la mesure de l'évolution de tension de la seconde ligne d'excitation par rapport à la masse a lieu du fait que la première entrée d'un convertisseur AD (23 ; 25) est mise au moins pour la durée de mesure au potentiel de masse et que sa seconde entrée est connectée au second raccordement (6) pour la ligne d'excitation.

5. Procédé selon une des revendications 1 à 4, dans lequel le calcul (35) des amplitudes et des valeurs de décalage des évolutions de tension à dépendance temporelle a lieu du fait que les maxima et les minima des évolutions de tension à dépendance temporelle sont déterminés, que les amplitudes sont calculées en faisant la différence entre les maxima et les minima déterminés des évolutions de tension à dépendance temporelle, et les valeurs de décalage sont calculées en faisant la somme des maxima et des minima déterminés des évolutions de tension à dépendance temporelle.

**6.** Procédé selon une des revendications 1 à 5, dans lequel l'identification (36) du potentiel sur lequel la ligne affectée de court-circuit est tirée a lieu du fait que les valeurs de décalage sont comparées à une valeur seuil pour le potentiel de masse et à une valeur seuil pour le potentiel de tension de service.

**7.** Circuit de détection d'un court-circuit (10) d'une ligne d'excitation (11, 12) d'un résolveur (16), présentant

• un dispositif de commande (1) comportant un processeur (2), des niveaux de puissance (3, 4), des premiers raccordements pour émettre des signaux pour les lignes d'excitation (11, 12) vers la bobine d'excitation (16) du résolveur (15) et des seconds raccordements (7, 8) pour connecter les lignes de signaux (13, 14) pour les signaux de la bobine sinusoïdale et cosinusoïdale (17, 18) ; et deux convertisseurs AD (21, 22) qui sont raccordés aux seconds raccordements (7, 8) du dispositif de commande (1) et dont les sorties sont lisibles et exploitables par le processeur (2) ;
• les lignes d'excitation à diagnostiquer (11, 12) qui couplent les premiers raccordements (5, 6) à la bobine d'excitation (16) du résolveur (15) ;
• les lignes de signaux (13, 14) pour les signaux sinusoïdaux et coinusoïdaux fournis par le résolveur (15) qui couplent le résolveur aux seconds raccordements (7, 8) du dispositif de commande (1) ;
• un troisième convertisseur AD (23) dont les entrées sont connectées aux premiers raccordements (5, 6) pour les lignes d'excitation (11, 12) ;
•

- soit :
un quatrième et un cinquième convertisseur AD (24, 25) dans lesquels respectivement une entrée est connectée à la masse et l'autre entrée à un des premiers raccordements (5, 6) pour les lignes d'excitation (11, 12) ;
- soit :
deux commutateurs électroniques qui sont intégrés dans la connexion des raccordements (5, 6) pour les lignes d'excitation (11, 12) à des entrées du troisième convertisseur AD (23), les commutateurs étant conçus pour séparer respectivement une entrée du convertisseur AD (23) de la ligne d'excitation (11, 12) et connecter temporairement cette entrée à la masse ; et

• un dispositif d'affichage et/ou de sauvegarde (9) pour afficher et/ou sauvegarder les informations identifiées par le processeur (2) et dans lequel est intégrée la détection positive d'un court-circuit (10) de la bobine d'excitation (17 ; 18) d'un résolveur (16) et la désignation de la ligne affectée de court-circuit (11, 12) et du potentiel sur lequel cette ligne peut être tirée ; le processeur (2) étant conçu pour mettre en oeuvre le procédé (31-37) selon la revendication 1.

**8.** Circuit selon la revendication 7, dans lequel les troisième, quatrième et cinquième convertisseurs AD (23, 24, 25) ou le troisième convertisseur AD (23) et les deux commutateurs électroniques sont intégrés dans le dispositif de commande (1).

# Fig. 1

EP 3 311 114 B1

# Fig. 2

31 32 33 34 35 36 37

# Fig. 3

— Erreger-High
-- - Erreger-Low

Spannung in V

20

15

10

0             1     Zeit in s      2            3

— ExcHi-ExcLo

Differentielle Spannung in V

10

5

0

-5

-10

0             1     Zeit in s      2            3

$\times 10^{-4}$

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1548411 A1

- DE 102011078583 A1